# EUROPEAN PATENT APPLICATION

(11) **EP 2 670 074 A2**
(43) Date of publication of application: **04.12.2013**
(21) Application number: 13160629.5
(22) Date of filing: 22.03.2013
(51) Int. Cl.: H04L 1/00

(54) **Systems and methods for data processing including EET feedback**

(30) Priority: 30.05.2012 US 201213483100
(71) Applicant: LSI Corporation, Milpitas, CA 95035 (US)
(72) Inventor: Zhang, Fan, Milpitas, CA 95035 (US); Wang, Chung-Li, San Jose, CA 95127 (US); Han, Yang, Sunnyvale, CA 94087 (US); Yang, Shaohua, San Jose, CA 95129 (US); Wu, Xuebin, San Jose, CA 95131 (US); Xia, Haitao, San Jose, CA 95131 (US); Jin, Ming, Fremond, CA 94539 (US)
(74) Representative: Ford, Esther Mary

(57) **Abstract**

The present invention is related to systems and methods for data processing system characterization. An embodiment of a data processing system comprises: a data processing circuit, wherein the data processing circuit includes: a data detector circuit operable to apply a data detection algorithm to a sample data set to yield a detected output; a detected output error count circuit operable to generate an output side error count corresponding to a number of errors remaining in the detected output, wherein the detected output error count circuit is operable to provide the output side error count external to the data processing circuit; a data decoder circuit operable to apply a data decoding algorithm to the detected output to yield a decoded output; and a decoded output error count circuit operable to generate an input side error count corresponding to a number of errors remaining in the decoded output, wherein the decoded output error count circuit is operable to provide the input side error count external to the data processing circuit

## Description

### BACKGROUND OF THE INVENTION

The present invention is related to systems and methods for data processing system characterization.

Various data transfer systems have been developed including storage systems, cellular telephone systems, radio transmission systems. In each of the systems data is transferred from a sender to a receiver via some medium. For example, in a storage system, data is sent from a sender (i.e., a write function) to a receiver (i.e., a read function) via a storage medium. In some cases, an iterative codec system is used for data processing that includes a data detector circuit and a data decoder circuit that iteratively pass extrinsic log likelihood ratio (LLR) data to each other. Traditionally, such iterative codec systems are analyzed and optimized by using an extrinsic information transfer chart. The precise calculation of such an extrinsic information transfer chart is very complex, and to reduce the complexity to a manageable level various assumptions are incorporated to develop the chart. Analysis based on the chart is plagued by inaccuracies in significant part arise from the assumptions.

Hence, for at least the aforementioned reasons, there exists a need in the art for advanced systems and methods data processing circuit analysis.

### BRIEF SUMMARY OF THE INVENTION

According to a first aspect of the present invention, there is provided a data processing system according to appended claim 1.

According to a second aspect of the present invention, there is provided a data processing circuit analysis system according to appended claim 9.

According to a third aspect of the present invention, there is provided a storage device according to appended claim 15.

Preferred embodiments are defined in the appended dependent claims.

### BRIEF DESCRIPTION OF THE DRAWINGS

A further understanding of the various embodiments of the present invention may be realized by reference to the figures which are described in remaining portions of the specification. In the figures, like reference numerals are used throughout several figures to refer to similar components. In some instances, a sub-label consisting of a lower case letter is associated with a reference numeral to denote one of multiple similar components. When reference is made to a reference numeral without specification to an existing sub-label, it is intended to refer to all such multiple similar components.

Fig. 1 depicts a data processing circuit having EET related error output circuitry in accordance with one or more embodiments of the present invention;

Fig. 2 shows another data processing circuit having EET related error output circuitry in accordance with one or more embodiments of the present invention;

Figs. 3a-3f are flow diagrams and example graphics showing a method in accordance with some embodiments for reporting operation status and analyzing the status to identify improved parameters;

Figs. 4a-4c are flow diagrams showing another method in accordance with some embodiments for reporting operation status and analyzing the status to identify improved parameters;

Fig. 5 shows an analysis system for analyzing data processing circuit operation in accordance with one or more embodiments of the present invention;

Fig. 6 shows a storage device including a read channel having error feedback circuitry in accordance with one or more embodiments of the present invention; and

Fig. 7 shows a data transmission device including a receiver having error feedback circuitry in accordance with some embodiments of the present invention.

### DETAILED DESCRIPTION OF THE INVENTION

Embodiments of the present inventions are related to systems and methods for performing data processing, and more specifically to systems and methods for adaptive parameter modification in a data processing system.

Various embodiments of the present inventions provide data processing systems that include a data processing circuit. The data processing circuit includes a data detector circuit operable to apply a data detection algorithm to a sample data set to yield a detected output, and a detected output error count circuit operable to generate an output side error count corresponding to a number of errors remaining in the detected output. The detected output error count circuit is operable to provide the output side error count external to the data processing circuit. In addition, a data decoder circuit is included that is operable to apply a data decoding algorithm to the detected output to yield a decoded output, and a decoded output error count circuit operable to generate an input side error count corresponding to a number of errors remaining in the decoded output. The decoded output error count circuit is operable to provide the input side error count external to the data processing circuit. In some cases, the data processing system is implemented as part of a storage device or a receiving device. In some such cases the input side error count and the output side error count are provided external to the device. In other cases, the data processing system is implemented as part of an integrated circuit. In some such cases, the input side error count and the output side error count are provided external to the integrated circuit.

In some instances of the aforementioned embodiments where the input side error count is a first input side error count, the decoded output is a first decoded output corresponding to a first local iteration of applying the decoding algorithm to the detected output, the data decoder circuit is operable to apply the data decoding algorithm to the detected output to yield a second decoded output corresponding to a first local iteration of applying the decoding algorithm to the detected output. The decoded output error count circuit is further operable to generate a second input side error count corresponding to a number of errors remaining in the second decoded output. In particular instances of the aforementioned embodiments, the system further includes a processor and a computer readable medium. The computer readable medium includes instructions executable by the processor to determine a characteristic of the data processing circuit based at least in part on the input side error count and the output side error count. In one or more cases, the instructions executable by the processor include instructions executable to plot a plurality of output side error counts and a plurality of input side error counts. In particular cases, the instructions executable by the processor include instructions executable to average the plurality of output side error counts to yield a first curve, and to average the plurality of input side error counts to yield a second curve.

The above provides only a general outline of some embodiments of the invention. Many other objects, features, advantages and other embodiments of the invention will become more fully apparent from the following detailed description, the appended claims and the accompanying drawings.

Various embodiments of the present invention provide data processing circuits that include a data detector circuit and a data decoder circuit. The data detector circuit and data decoder circuit iteratively feed information between each other as part of a data processing algorithm. In particular, a detected output from the data detector circuit is provided to the data decoder circuit that applies a data decode algorithm in an attempt to recover an originally written data set. Where application of the data decode algorithm yields the originally written data set, the decoded output is said to have "converged". In some cases, such convergence is indicated by satisfaction of all parity check equations relied upon in the data decode algorithm. Based upon the disclosure provided herein, one of ordinary skill in the art will recognize a variety of scenarios in which the decoded output is considered to have converged. Such a converged data set is provided as an output from the data processing circuit.

Where application of the data decoding algorithm fails to converge, the decoded output may be provided back to the data detector circuit to guide a subsequent application of the data detection algorithm applied by the data detector circuit and later processing through the data decoder circuit. A pass through both the data detector circuit and the data decoder circuit is referred to herein as a "global iteration". In some cases, the data processing circuit is designed to allow multiple global iterations. In various cases, the data decoding circuit may apply the data decode algorithm to the detected output multiple times during a given global iteration. In such cases, each application of the data decode algorithm is referred to herein as a "local iteration".

In various embodiments of the present inventions, a first error count circuit is included to count the errors remaining in a detected output and a second error count circuit is included to count the errors remaining in a decoded output at the end of a given global iteration. In one particular embodiment of the present invention, a third error count circuit is included to count the number of errors remaining in the decoded output at the end of each local iteration through the data decoder circuit. In some cases, data from the error count circuits is provided to an analysis system that determines one or more parameter changes based upon the various numbers of errors.

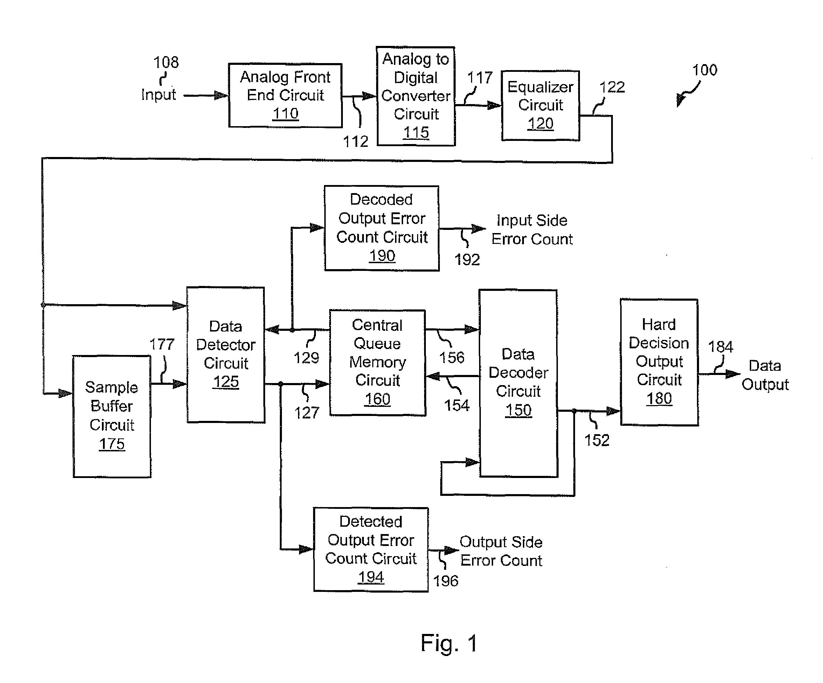

Turning to Fig. 1, a data processing circuit 100 having extrinsic error transfer (hereinafter 'EET') related error output circuitry is shown in accordance with some embodiments of the present invention. Data processing circuit 100 includes an analog front end circuit 110 that receives an analog input 108. Analog front end circuit 110 processes analog input 108 and provides a processed analog signal 112 to an analog to digital converter circuit 115. Analog front end circuit 110 may include, but is not limited to, an analog filter and an amplifier circuit as are known in the art. Based upon the disclosure provided herein, one of ordinary skill in the art will recognize a variety of circuitry that may be included as part of analog front end circuit 110. In some cases, analog input 108 is derived from a read/write head assembly (not shown) that is disposed in relation to a storage medium (not shown). In other cases, analog input 108 is derived from a receiver circuit (not shown) that is operable to receive a signal from a transmission medium (not shown). The transmission medium may be wired or wireless. Based upon the disclosure provided herein, one of ordinary skill in the art will recognize a variety of sources from which analog input 108 may be derived.

Analog to digital converter circuit 115 converts processed analog signal 112 into a corresponding series of digital samples 117. Analog to digital converter circuit 115 may be any circuit known in the art that is capable of producing digital samples corresponding to an analog input signal. Based upon the disclosure provided herein, one of ordinary skill in the art will recognize a variety of analog to digital converter circuits that may be used in relation to different embodiments of the present invention. Digital samples 117 are provided to an equalizer circuit 120. Equalizer circuit 120 applies an equalization algorithm to digital samples 117 to yield an equalized output 122. In some embodiments of the present invention, equalizer circuit 120 is a digital finite impulse response filter circuit as are known in the art.

Equalized output 122 is provided to both a data detector circuit 125 and to a sample buffer circuit 175. Sample buffer circuit 175 stores equalized output 122 as buffered data 177 for use in subsequent iterations through data detector circuit 125. Data detector circuit 125 may be any data detector circuit known in the art that is capable of producing a detected output 127. As some examples, data detector circuit 125 may be, but is not limited to, a Viterbi algorithm detector circuit or a maximum a posteriori detector circuit as are known in the art. Of note, the general phrases "Viterbi data detection algorithm" or "Viterbi algorithm data detector circuit" are used in their broadest sense to mean any Viterbi detection algorithm or Viterbi algorithm detector circuit or variations thereof including, but not limited to, bi-direction Viterbi detection algorithm or bi-direction Viterbi algorithm detector circuit. Also, the general phrases "maximum a posteriori data detection algorithm" or "maximum a posteriori data detector circuit" are used in their broadest sense to mean any maximum a posteriori detection algorithm or detector circuit or variations thereof including, but not limited to, simplified maximum a posteriori data detection algorithm and a max-log maximum a posteriori data detection algorithm, or corresponding detector circuits. Based upon the disclosure provided herein, one of ordinary skill in the art will recognize a variety of data detector circuits that may be used in relation to different embodiments of the present invention. Detected output 125 may include both hard decisions and soft decisions. The terms "hard decisions" and "soft decisions" are used in their broadest sense. In particular, "hard decisions" are outputs indicating an expected original input value (e.g., a binary '1' or '0', or a non-binary digital value), and the "soft decisions" indicate a likelihood that corresponding hard decisions are correct. Based upon the disclosure provided herein, one of ordinary skill in the art will recognize a variety of hard decisions and soft decisions that may be used in relation to different embodiments of the present invention.

Detected output 127 is provided to a central queue memory circuit 160 that operates to buffer data passed between data detector circuit 125 and data decoder circuit 150. In some cases, central queue memory circuit 160 includes interleaving (i.e., data shuffling) and de-interleaving (i.e., data un-shuffling) circuitry known in the art. When data decoder circuit 150 is available, data decoder circuit 150 accesses detected output 127 from central queue memory circuit 160 as a decoder input 156. Data decoder circuit 150 applies a data decoding algorithm to decoder input 156 in an attempt to recover originally written data. The result of the data decoding algorithm is provided as a decoded output 152. Similar to detected output 127, decoded output 152 may include both hard decisions and soft decisions. For example, data decoder circuit 150 may be any data decoder circuit known in the art that is capable of applying a decoding algorithm to a received input. Data decoder circuit 150 may be, but is not limited to, a low density parity check (LDPC) decoder circuit or a Reed Solomon decoder circuit as are known in the art. Based upon the disclosure provided herein, one of ordinary skill in the art will recognize a variety of data decoder circuits that may be used in relation to different embodiments of the present invention. Where the original data is recovered (i.e., the data decoding algorithm converges) or a timeout condition occurs, decoded output 152 is stored to a memory included in a hard decision output circuit 180. In turn, hard decision output circuit 180 provides the converged decoded output 152 as a data output 184 to a recipient (not shown). The recipient may be, for example, an interface circuit operable to receive processed data sets. Based upon the disclosure provided herein, one of ordinary skill in the art will recognize a variety of recipients that may be used in relation to different embodiments of the present invention. Where the original data is not recovered (i.e., the data decoding algorithm failed to converge) prior to a timeout condition, decoded output 152 indicates that the data is unusable as is more specifically discussed below, and data output 184 is similarly identified as unusable.

One or more iterations through the combination of data detector circuit 125 and data decoder circuit 150 may be made in an effort to converge on the originally written data set. As mentioned above, processing through both the data detector circuit and the data decoder circuit is referred to as a global iteration. For the first global iteration, data detector circuit 125 applies the data detection algorithm to equalized output 122 without guidance from a decoded output. For subsequent global iterations, data detector circuit 125 applies the data detection algorithm to buffered data177 as guided by decoded output 152. To facilitate this guidance, decoded output 152 is stored to central queue memory circuit 160 as a decoder output 154, and is provided from central queue memory circuit 160 as a detector input 129 when equalized output 122 is being reprocessed through data detector circuit 125.

During each global iteration it is possible for data decoder circuit 150 to make one or more local iterations including application of the data decoding algorithm to decoder input 156. For the first local iteration, data decoder circuit 150 applies the data decoder algorithm without guidance from decoded output 152. For subsequent local iterations, data decoder circuit 150 applies the data decoding algorithm to decoder input 156 as guided by a previous decoded output 152. The number of local iterations allowed may be, for example, ten. Based upon the disclosure provided herein, one of ordinary skill in the art will recognize a variety of different numbers of local iterations that may be allowed in accordance with different embodiments of the present invention. Where the number of local iterations through data decoder circuit 150 exceeds that allowed, but it is determined that at least one additional global iteration during standard processing of the data set is allowed, decoded output 152 is provided back to central queue memory circuit 160 as decoded output 154. Decoded output 154 is maintained in central queue memory circuit 160 until data detector circuit 125 becomes available to perform additional processing.

In contrast, where the number of local iterations through data decoder circuit 150 exceeds that allowed and it is determined that the allowable number of global iterations has been surpassed for the data set and/or a timeout or memory usage calls for termination of processing of the particular data set, standard processing of the data set concludes and an error is indicated. In some cases, retry processing or some offline processing may be applied to recover the otherwise unconverged data set. Based upon the disclosure provided herein, one of ordinary skill in the art will recognize a variety of non-standard processing techniques that may be applied to recover the otherwise unrecoverable data set.

Detected output 127 is provided to a detected output error count circuit 194 that is operable to determine a number of unsatisfied checks or errors that remain after application of the data detection algorithm by data detector circuit 125. Detector input 129 (i.e., corresponding to decoded output 154) is also provided to a decoded output error count circuit 190 that is operable to determine a number of unsatisfied checks or errors that remain after application of the data decode algorithm by data decoder circuit 150 at the end of a given global iteration. An input side error count 192 from decoded output error count circuit 190 and an output side error count 196 from detected output error count circuit 194 are provided to an analysis system (not shown) where corresponding instances thereof are used to identify improved parameters for data processing circuit 100.

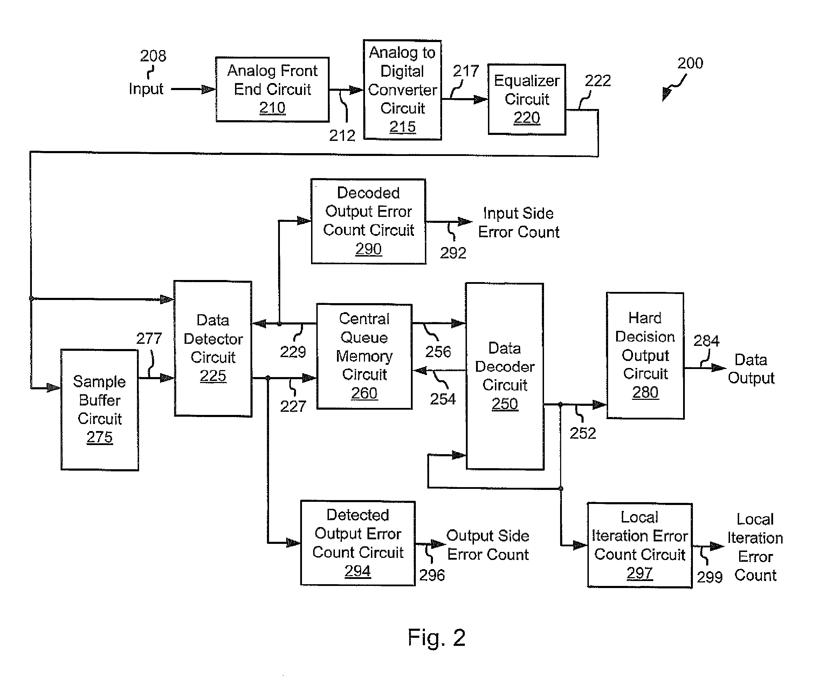

Turning to Fig. 2, a data processing circuit 200 having EET related error output circuitry is shown in accordance with some embodiments of the present invention. Data processing circuit 200 includes an analog front end circuit 210 that receives an analog input 208. Analog front end circuit 210 processes analog input 208 and provides a processed analog signal 212 to an analog to digital converter circuit 215. Analog front end circuit 210 may include, but is not limited to, an analog filter and an amplifier circuit as are known in the art. Based upon the disclosure provided herein, one of ordinary skill in the art will recognize a variety of circuitry that may be included as part of analog front end circuit 210. In some cases, analog input 208 is derived from a read/write head assembly (not shown) that is disposed in relation to a storage medium (not shown). In other cases, analog input 208 is derived from a receiver circuit (not shown) that is operable to receive a signal from a transmission medium (not shown). The transmission medium may be wired or wireless. Based upon the disclosure provided herein, one of ordinary skill in the art will recognize a variety of sources from which analog input 208 may be derived.

Analog to digital converter circuit 215 converts processed analog signal 212 into a corresponding series of digital samples 217. Analog to digital converter circuit 215 may be any circuit known in the art that is capable of producing digital samples corresponding to an analog input signal. Based upon the disclosure provided herein, one of ordinary skill in the art will recognize a variety of analog to digital converter circuits that may be used in relation to different embodiments of the present invention. Digital samples 217 are provided to an equalizer circuit 220. Equalizer circuit 220 applies an equalization algorithm to digital samples 217 to yield an equalized output 222. In some embodiments of the present invention, equalizer circuit 220 is a digital finite impulse response filter circuit as are known in the art.

Equalized output 222 is provided to both a data detector circuit 225 and to a sample buffer circuit 275. Sample buffer circuit 275 stores equalized output 222 as buffered data 277 for use in subsequent iterations through data detector circuit 225. Data detector circuit 225 may be any data detector circuit known in the art that is capable of producing a detected output 227. As some examples, data detector circuit 225 may be, but is not limited to, a Viterbi algorithm detector circuit or a maximum a posteriori detector circuit as are known in the art. Of note, the general phrases "Viterbi data detection algorithm" or "Viterbi algorithm data detector circuit" are used in their broadest sense to mean any Viterbi detection algorithm or Viterbi algorithm detector circuit or variations thereof including, but not limited to, bi-direction Viterbi detection algorithm or bi-direction Viterbi algorithm detector circuit. Also, the general phrases "maximum a posteriori data detection algorithm" or "maximum a posteriori data detector circuit" are used in their broadest sense to mean any maximum a posteriori detection algorithm or detector circuit or variations thereof including, but not limited to, simplified maximum a posteriori data detection algorithm and a max-log maximum a posteriori data detection algorithm, or corresponding detector circuits. Based upon the disclosure provided herein, one of ordinary skill in the art will recognize a variety of data detector circuits that may be used in relation to different embodiments of the present invention. Detected output 225 may include both hard decisions and soft decisions. The terms "hard decisions" and "soft decisions" are used in their broadest sense. In particular, "hard decisions" are outputs indicating an expected original input value (e.g., a binary '1' or '0', or a non-binary digital value), and the "soft decisions" indicate a likelihood that corresponding hard decisions are correct. Based upon the disclosure provided herein, one of ordinary skill in the art will recognize a variety of hard decisions and soft decisions that may be used in relation to different embodiments of the present invention.

Detected output 227 is provided to a central queue memory circuit 260 that operates to buffer data passed between data detector circuit 225 and data decoder circuit 250. In some cases, central queue memory circuit 260 includes interleaving (i.e., data shuffling) and de-interleaving (i.e., data un-shuffling) circuitry known in the art. When data decoder circuit 250 is available, data decoder circuit 250 accesses detected output 227 from central queue memory circuit 260 as a decoder input 256. Data decoder circuit 250 applies a data decoding algorithm to decoder input 256 in an attempt to recover originally written data. The result of the data decoding algorithm is provided as a decoded output 252. Similar to detected output 227, decoded output 252 may include both hard decisions and soft decisions. For example, data decoder circuit 250 may be any data decoder circuit known in the art that is capable of applying a decoding algorithm to a received input. Data decoder circuit 250 may be, but is not limited to, a low density parity check (LDPC) decoder circuit or a Reed Solomon decoder circuit as are known in the art. Based upon the disclosure provided herein, one of ordinary skill in the art will recognize a variety of data decoder circuits that may be used in relation to different embodiments of the present invention. Where the original data is recovered (i.e., the data decoding algorithm converges) or a timeout condition occurs, decoded output 252 is stored to a memory included in a hard decision output circuit 280. In turn, hard decision output circuit 280 provides the converged decoded output 252 as a data output 284 to a recipient (not shown). The recipient may be, for example, an interface circuit operable to receive processed data sets. Based upon the disclosure provided herein, one of ordinary skill in the art will recognize a variety of recipients that may be used in relation to different embodiments of the present invention. Where the original data is not recovered (i.e., the data decoding algorithm failed to converge) prior to a timeout condition, decoded output 252 indicates that the data is unusable as is more specifically discussed below, and data output 284 is similarly identified as unusable.

One or more iterations through the combination of data detector circuit 225 and data decoder circuit 250 may be made in an effort to converge on the originally written data set. As mentioned above, processing through both the data detector circuit and the data decoder circuit is referred to as a global iteration. For the first global iteration, data detector circuit 225 applies the data detection algorithm to equalized output 222 without guidance from a decoded output. For subsequent global iterations, data detector circuit 225 applies the data detection algorithm to buffered data177 as guided by decoded output 252. To facilitate this guidance, decoded output 252 is stored to central queue memory circuit 260 as a decoder output 254, and is provided from central queue memory circuit 260 as a detector input 229 when equalized output 222 is being reprocessed through data detector circuit 225.

During each global iteration it is possible for data decoder circuit 250 to make one or more local iterations including application of the data decoding algorithm to decoder input 256. For the first local iteration, data decoder circuit 250 applies the data decoder algorithm without guidance from decoded output 252. For subsequent local iterations, data decoder circuit 250 applies the data decoding algorithm to decoder input 256 as guided by a previous decoded output 252. The number of local iterations allowed may be, for example, ten. Based upon the disclosure provided herein, one of ordinary skill in the art will recognize a variety of different numbers of local iterations that may be allowed in accordance with different embodiments of the present invention. Where the number of local iterations through data decoder circuit 250 exceeds that allowed, but it is determined that at least one additional global iteration during standard processing of the data set is allowed, decoded output 252 is provided back to central queue memory circuit 260 as decoded output 254. Decoded output 254 is maintained in central queue memory circuit 260 until data detector circuit 225 becomes available to perform additional processing.

In contrast, where the number of local iterations through data decoder circuit 250 exceeds that allowed and it is determined that the allowable number of global iterations has been surpassed for the data set and/or a timeout or memory usage calls for termination of processing of the particular data set, standard processing of the data set concludes and an error is indicated. In some cases, retry processing or some offline processing may be applied to recover the otherwise unconverged data set. Based upon the disclosure provided herein, one of ordinary skill in the art will recognize a variety of non-standard processing techniques that may be applied to recover the otherwise unrecoverable data set.

Detected output 227 is provided to a detected output error count circuit 294 that is operable to determine a number of unsatisfied checks or errors that remain after application of the data detection algorithm by data detector circuit 225. Detector input 229 (i.e., corresponding to decoded output 254) is also provided to a decoded output error count circuit 290 that is operable to determine a number of unsatisfied checks or errors that remain after application of the data decode algorithm by data decoder circuit 250 at the end of a given global iteration. In addition, decoded output 252 is provided to a local iteration error count circuit 297 that is operable to determine a number of unsatisfied checks or errors that remain after each local iteration applying the data decode algorithm by data decoder circuit 250. An input side error count 292 from decoded output error count circuit 290, an output side error count 296 from detected output error count circuit 294 are provided, and multiple local iteration error counts 299 (i.e., one for each local iteration) are provided to an analysis system (not shown) where corresponding instances thereof are used to identify improved parameters for data processing circuit 200.

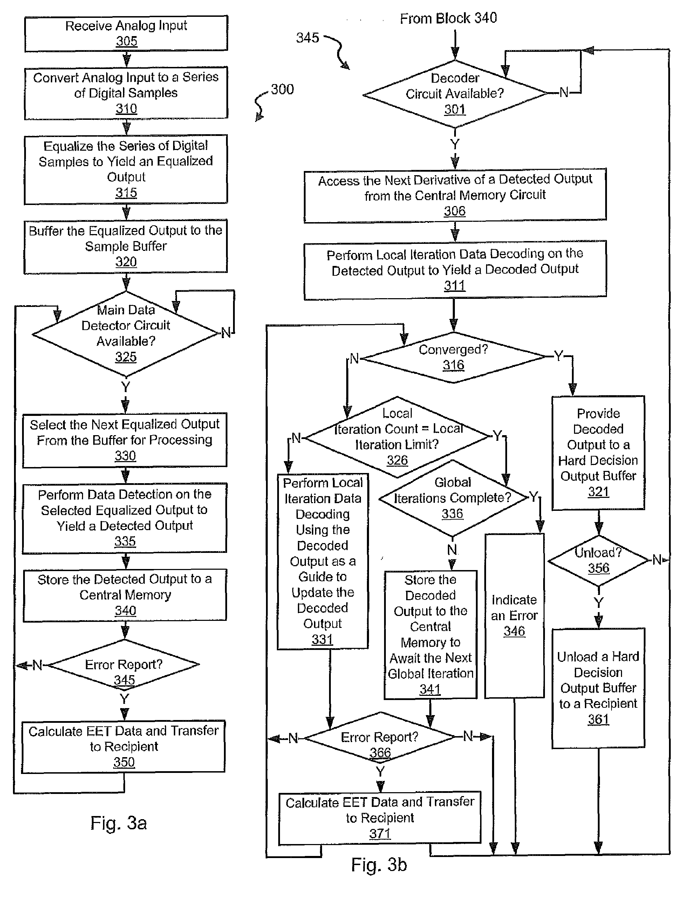

Turning to Figs. 3a-3f, flow diagrams 300, 345, 392, and graphs 303, 304 show a method in accordance with some embodiments for reporting operation status and analyzing the status to identify improved parameters. Following flow diagram 300 of Fig. 3a, an analog input is received (block 305). The analog input may be derived from, for example, a storage medium or a data transmission channel. Based upon the disclosure provided herein, one of ordinary skill in the art will recognize a variety of sources of the analog input. The analog input is converted to a series of digital samples (block 310). This conversion may be done using an analog to digital converter circuit or system as are known in the art. Of note, any circuit known in the art that is capable of converting an analog signal into a series of digital values representing the received analog signal may be used. The resulting digital samples are equalized to yield an equalized output (block 315). In some embodiments of the present invention, the equalization is done using a digital finite impulse response circuit as are known in the art. Based upon the disclosure provided herein, one of ordinary skill in the art will recognize a variety of equalizer circuits that may be used in place of such a digital finite impulse response circuit to perform equalization in accordance with different embodiments of the present invention. The equalized output is buffered (block 320).

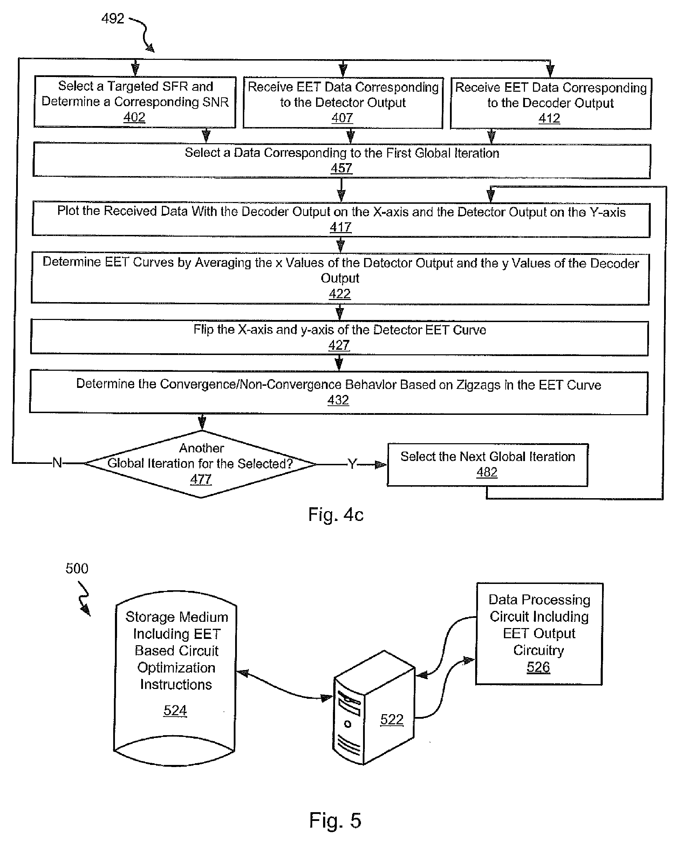

It is determined whether a data detector circuit is available (block 325). Where the data detector circuit is available (block 325), the next equalized output from the sample buffer is selected for processing (block 330), and a data detection is performed on the selected equalized output to yield a detected output (block 335). The detected output is then stored to a central memory (block 340). In addition, it is determined whether error reporting is enabled (block 345). Error reporting may be enabled, for example, based upon a user input during a test or analysis phase, and is disabled during a normal operational mode. Where error reporting is enabled (block 345), EET data is calculated and transferred to a recipient (block 350). This EET data includes the number of errors remaining in the detected output after applying the data detection algorithm. In some cases, the number of errors corresponds to a number of remaining unsatisfied checks. The recipient may be, for example, a data analysis system similar to that discussed below in relation to Fig. 5.

Turing to Fig. 3b and following flow diagram 345 it is determined whether a decoder circuit is available to process a previously stored the detected output (block 301). Where the decoder circuit is available (block 301), the next derivative of a detected output is selected for processing and accessed from the central memory circuit (block 306). A first local iteration of a data decoding algorithm is applied by the data decoder circuit to the selected detected output to yield a decoded output (block 311). In some embodiments of the present invention, the data decoding algorithm is a low density parity check algorithm.

It is then determined whether the decoded output converged (i.e., yielded a correct result) (block 316). Where the decoded output converged (block 316), the decoded output is provided to a hard decision output buffer (block 321). It is then determined whether the hard decision output buffer is ready to be unloaded (block 356). In some cases, the hard decision output buffer is ready to be unloaded when the most recently completed decoded output is the next decoded output after that previously provided as a data output. Where the hard decision output buffer is ready to be unloaded (block 356), all of the continuous decoded outputs maintained in the hard decision output buffer are provided as a data output to a recipient device (block 361). Based upon the disclosure provided herein, one of ordinary skill in the art will recognize a variety of recipient devices that may be used in relation to different embodiments of the present invention.

Alternatively, where the decoded output failed to converge (block 316), it is determined whether the local iteration count has exceeded a local iteration limit (block 326). This local iteration limit may be, for example, ten local iterations. Where the number of local iterations has not yet been exceeded (block 326), the data decoding algorithm is re-applied to the currently processing data set for a subsequent local iteration guided by the decoded output to yield an updated decoded output (block 331). The processes beginning at block 316 are then repeated. In addition, it is determined whether error reporting is enabled (block 366). Error reporting may be enabled, for example, based upon a user input during a test or analysis phase, and is disabled during a normal operational mode. Where error reporting is enabled (block 366), EET data is calculated for the current local iteration and transferred to a recipient (block 371). This EET data includes the number of errors remaining in the decoded output after the current local iteration applying the data decode algorithm. In some cases, the number of errors corresponds to a number of remaining unsatisfied checks. The recipient may be, for example, a data analysis system similar to that discussed below in relation to Fig. 5.

Alternatively, where the number of local iterations for the currently proceeding global iteration have been exceeded (block 326), it is determined if the maximum number of global iterations have already been applied to the currently processing data set (block 336). The number of global iterations may be complete where, for example, a timeout condition has occurred or a memory usage limitation has been exceeded. Where the global iterations are not complete (block 336), the decoded output is stored to the central memory where it awaits use in guiding application of the data detection algorithm during a subsequent global iteration (block 341). In addition, it is determined whether error reporting is enabled (block 366). Error reporting may be enabled, for example, based upon a user input during a test or analysis phase, and is disabled during a normal operational mode. Where error reporting is enabled (block 366), EET data is calculated for the decoded output at the end of the current global iteration and transferred to a recipient (block 371). This EET data includes the number of errors remaining in the decoded output after the current global iteration. In some cases, the number of errors corresponds to a number of remaining unsatisfied checks. The recipient may be, for example, a data analysis system similar to that discussed below in relation to Fig. 5. Alternatively, where the global iterations are complete (block 336), an error is indicated (block 346).

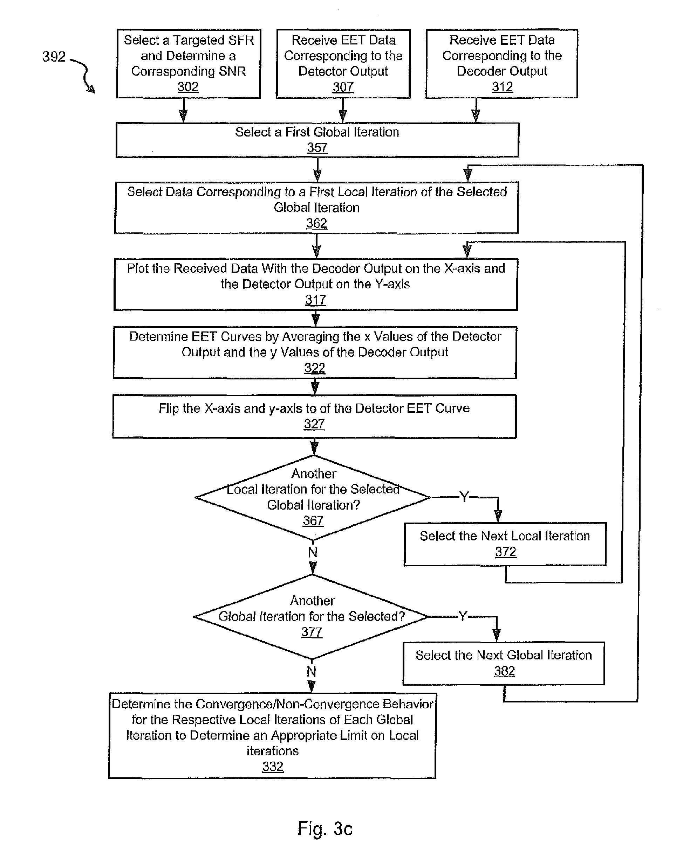

Turning to Fig. 3c, flow diagram 392 shows a method that may be implemented in an analysis system using the error data from a data processing circuit to improve one or more parameters of the data processing circuit. Following flow diagram 392, a targeted sector failure rate (SFR) to the data processing circuit is selected (block 302). Such a failure rate may indicate a rate of failures in a data decoding process that may be acceptable in an end design and may be selected based upon a particular expected circuit deployment. In parallel, the EET data corresponding to the detector output generated in block 350 and the EET data corresponding to the decoder output generated in block 371 (i.e., both the end of global iteration data and the end of each local iteration data) is received (blocks 307, 312).

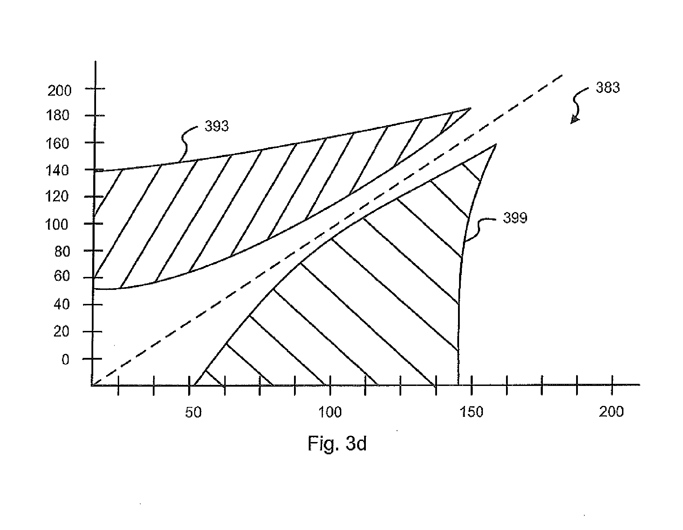

Data corresponding to the first global iteration is selected (block 357). This data includes one set of EET data corresponding to the detector output. In addition, data corresponding to a first local iteration of the selected global iteration is selected (block 362). The received data is plotted with the set of EET data corresponding to the decoder output on the x-axis and the set of EET data corresponding to the detector output on the y-axis (block 317). An example of such a plot 383 where the x-axis corresponds to the data as plotted in block 317 is shown in Fig. 3d. As shown, most values of the EET data corresponding to the detector output corresponding to the errors received from the decoded output are plotted along the y-axis and generally fall into a region 393. Most values of the EET data corresponding to the decoder output corresponding to the errors received from the detector output are plotted along the x-axis and generally fall into a region 399.

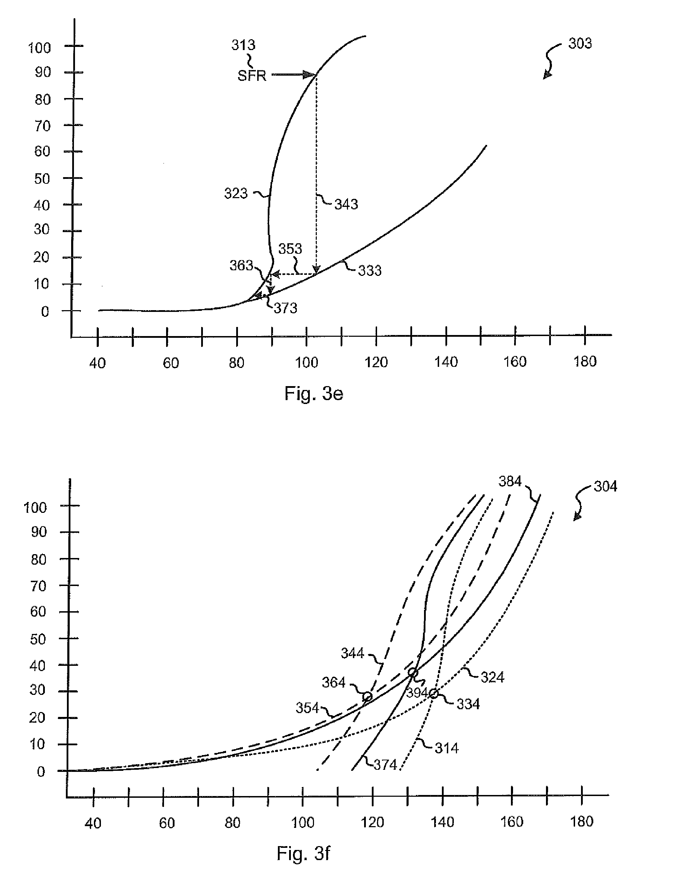

EET curves are then calculated and plotted by averaging the x-axis values and the y-axis values from the plot of block 317 (block 322). Using the example of Fig. 3d, this involves averaging the values included in region 393 to yield one curve, and averaging the values included in region 399 to yield another curve. The curve corresponding to the averaged x-axis values is then flipped with the curve corresponding to the y-axis values to yield a pair of EET curves (block 327). Referring to Fig. 3e, a plot 303 shows example EET curves 323, 333 corresponding to regions 393, 399. As shown, the targeted sector failure rate 313 is plotted with a vertical line 343 extending therefrom toward EET curve 333, followed by a horizontal line 353 extending from the intersection of vertical line 343 and EET curve 333 toward EET curve 323, followed by a vertical line 363 extending from the intersection of horizontal line 353 and EET curve 323 to EET curve 333, and followed by a horizontal line 373 extending from the intersection of vertical line 363 and EET curve 333 toward EET curve 323. These zigzag transitions (represented by lines 343, 353, 363, 373) between the remaining errors at the end of the data detection and the respective local iteration of the data decoding, and thereby the number of global iterations that would be expected to be used if the number of local iterations corresponding to the current number of local iterations.

It is determined whether there is another local iteration for the selected global iteration (block 367). Where there is data for another local iteration (block 367), the next local iteration is selected (block 372), and the processes of blocks 317, 322, 327, 367 are repeated for the next local iteration. Alternatively, where there is not data for another local iteration (block 367), it is determined whether data for another global iteration exists (block 377). Where there is data for another global iteration (block 377), the next global iteration is selected (block 382), and the processes of blocks 362, 317, 322, 327, 367, 372, 377 are repeated for the next global iteration. This results in a number of plots for the respective EET curves corresponding to all of the global iterations and the respective local iterations therein.

The convergence/non-convergence behavior is then determined including determining a desired number of local iterations for each global iteration (block 332). This may be done in accordance with the following pseudocode:

```
        For (Global Iteration = 1 to Maximum Allowable Global Iterations) {
          For (Local Iteration = 1 to Maximum Allowable Local Iterations) {
               Plot the EET Chart for the Particular Combination of Local and Global Iteration;
          }
          Select the Best Local Iteration for Each Global Iteration;
          Set the Maximum Number of Local Iterations for the Global Iterations Based on the
               Best Local Iteration;
        }
```

In one particular embodiment of the present invention, the best local iteration corresponds to the pair of EET curves (i.e., decoder EET curve and detector EET curve) that intersect with the value of one of the EET curves plus the value of the other EET curve at the intersection being the smallest.

Such pseudocode results in a number of EET curves plotted for each combination of global and local iterations (e.g., Global Iteration = 1 and Local Iteration = 3). Fig. 3f shows a plot 304 of an example of a number of EET curves for multiple different local iterations in a given global iteration. In particular, plot 304 includes pairs of curves (i.e., pairs 314, 324; 344, 354; and 374, 384). Based upon the location of the intersection of the pairs (i.e., intersections 334, 364, 394) an appropriate number of local iterations for a given global iteration and sector failure rate can be determined. The value of EET curve 314 at intersection 334 is 27 (y-axis) and the value of EET curve 324 at intersection 334 is 126 (x-axis) for a total of 153 (i.e., 26 + 127) at intersection 334. The value of EET curve 344 at intersection 364 is 27 (y-axis) and the value of EET curve 354 at intersection 364 is 117 (x-axis) for a total of 144 (i.e., 27 + 117) at intersection 364. The value of EET curve 374 at intersection 394 is 36 (y-axis) and the value of EET curve 384 at intersection 394 is 130 (x-axis) for a total of 166 (i.e., 36 + 130) at intersection 364. Thus, the best number of local iterations for the given global iteration is selected to be the number of local iterations corresponding to the EET curve pair 344, 354.

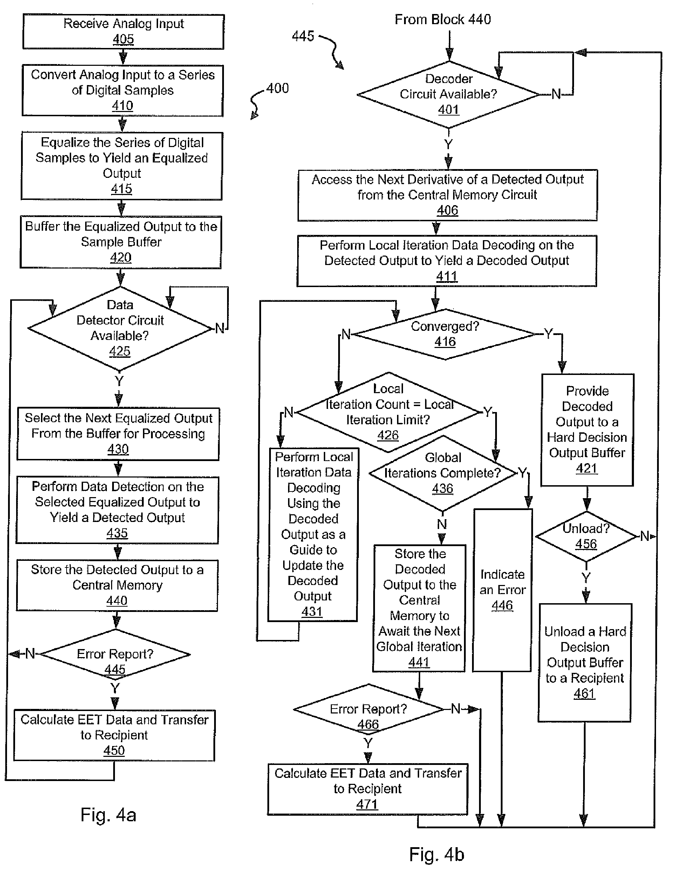

Turning to Figs. 4a-4c, flow diagrams 400, 445, 492 show a method in accordance with some embodiments for reporting operation status and analyzing the status to identify improved parameters. Following flow diagram 400 of Fig. 4a, an analog input is received (block 405). The analog input may be derived from, for example, a storage medium or a data transmission channel. Based upon the disclosure provided herein, one of ordinary skill in the art will recognize a variety of sources of the analog input. The analog input is converted to a series of digital samples (block 410). This conversion may be done using an analog to digital converter circuit or system as are known in the art. Of note, any circuit known in the art that is capable of converting an analog signal into a series of digital values representing the received analog signal may be used. The resulting digital samples are equalized to yield an equalized output (block 415). In some embodiments of the present invention, the equalization is done using a digital finite impulse response circuit as are known in the art. Based upon the disclosure provided herein, one of ordinary skill in the art will recognize a variety of equalizer circuits that may be used in place of such a digital finite impulse response circuit to perform equalization in accordance with different embodiments of the present invention. The equalized output is buffered (block 420).

It is determined whether a data detector circuit is available (block 425). Where the data detector circuit is available (block 425), the next equalized output from the sample buffer is selected for processing (block 430), and a data detection is performed on the selected equalized output to yield a detected output (block 435). The detected output is then stored to a central memory (block 440). In addition, it is determined whether error reporting is enabled (block 445). Error reporting may be enabled, for example, based upon a user input during a test or analysis phase, and is disabled during a normal operational mode. Where error reporting is enabled (block 445), EET data is calculated and transferred to a recipient (block 450). This EET data includes the number of errors remaining in the detected output after applying the data detection algorithm. In some cases, the number of errors corresponds to a number of remaining unsatisfied checks. The recipient may be, for example, a data analysis system similar to that discussed below in relation to Fig. 5.

Turing to Fig. 4b and following flow diagram 445 it is determined whether a decoder circuit is available to process a previously stored the detected output (block 401). Where the decoder circuit is available (block 401), the next derivative of a detected output is selected for processing and accessed from the central memory circuit (block 406). A first local iteration of a data decoding algorithm is applied by the data decoder circuit to the selected detected output to yield a decoded output (block 411). In some embodiments of the present invention, the data decoding algorithm is a low density parity check algorithm.

It is then determined whether the decoded output converged (i.e., yielded a correct result) (block 416). Where the decoded output converged (block 416), the decoded output is provided to a hard decision output buffer (block 421). It is then determined whether the hard decision output buffer is ready to be unloaded (block 456). In some cases, the hard decision output buffer is ready to be unloaded when the most recently completed decoded output is the next decoded output after that previously provided as a data output. Where the hard decision output buffer is ready to be unloaded (block 456), all of the continuous decoded outputs maintained in the hard decision output buffer are provided as a data output to a recipient device (block 461). Based upon the disclosure provided herein, one of ordinary skill in the art will recognize a variety of recipient devices that may be used in relation to different embodiments of the present invention.

Alternatively, where the decoded output failed to converge (block 416), it is determined whether the local iteration count has exceeded a local iteration limit (block 426). This local iteration limit may be, for example, ten local iterations. Where the number of local iterations has not yet been exceeded (block 426), the data decoding algorithm is re-applied to the currently processing data set for a subsequent local iteration guided by the decoded output to yield an updated decoded output (block 431). The processes beginning at block 416 are then repeated.

Alternatively, where the number of local iterations for the currently proceeding global iteration have been exceeded (block 426), it is determined if the maximum number of global iterations have already been applied to the currently processing data set (block 436). The number of global iterations may be complete where, for example, a timeout condition has occurred or a memory usage limitation has been exceeded. Where the global iterations are not complete (block 436), the decoded output is stored to the central memory where it awaits use in guiding application of the data detection algorithm during a subsequent global iteration (block 441). In addition, it is determined whether error reporting is enabled (block 466). Error reporting may be enabled, for example, based upon a user input during a test or analysis phase, and is disabled during a normal operational mode. Where error reporting is enabled (block 466), EET data is calculated for the decoded output at the end of the current global iteration and transferred to a recipient (block 471). This EET data includes the number of errors remaining in the decoded output after the current global iteration. In some cases, the number of errors corresponds to a number of remaining unsatisfied checks. The recipient may be, for example, a data analysis system similar to that discussed below in relation to Fig. 5. Alternatively, where the global iterations are complete (block 436), an error is indicated (block 446).

Turning to Fig. 4c, flow diagram 492 shows a method that may be implemented in an analysis system using the error data from a data processing circuit to improve one or more parameters of the data processing circuit. Following flow diagram 492, a targeted sector failure rate (SFR) to the data processing circuit is selected (block 402). Such a failure rate may indicate a rate of failures in a data decoding process that may be acceptable in an end design and may be selected based upon a particular expected circuit deployment. In parallel, the EET data corresponding to the detector output generated in block 450 and the EET data corresponding to the decoder output generated in block 471 is received (blocks 407, 412).

Data corresponding to the first global iteration is selected (block 457), and the selected data is plotted with the set of EET data corresponding to the decoder output on the x-axis and the set of EET data corresponding to the detector output on the y-axis (block 417). Referring to Fig. 3d, an example of such a plot 383 where the x-axis corresponds to the data as plotted in block 417. As shown in Fig. 3d, most values of the EET data corresponding to the detector output corresponding to the errors received from the decoded output are plotted along the y-axis and generally fall into a region 393. Most values of the EET data corresponding to the decoder output corresponding to the errors received from the detector output are plotted along the x-axis and generally fall into a region 399.

EET curves are then calculated and plotted by averaging the x-axis values and the y-axis values from the plot of block 417 (block 422). Using the example of Fig. 3d, this involves averaging the values included in region 393 to yield one curve, and averaging the values included in region 399 to yield another curve. The curve corresponding to the averaged x-axis values is then flipped with the curve corresponding to the y-axis values to yield a pair of EET curves (block 427). Referring to Fig. 3e, a plot 303 shows example EET curves 323, 333 corresponding to regions 393, 399. As shown, the targeted sector failure rate 313 is plotted with a vertical line 343 extending therefrom toward EET curve 333, followed by a horizontal line 353 extending from the intersection of vertical line 343 and EET curve 333 toward EET curve 323, followed by a vertical line 363 extending from the intersection of horizontal line 353 and EET curve 323 to EET curve 333, and followed by a horizontal line 373 extending from the intersection of vertical line 363 and EET curve 333 toward EET curve 323. These zigzag transitions (represented by lines 343, 353, 363, 373) between the remaining errors at the end of the data detection and the respective local iteration of the data decoding, and thereby the number of global iterations that would be expected to be used if the number of local iterations corresponding to the current number of local iterations.

The EET curves are then used to determine convergence/non-convergence behavior base on the zigzags (block 432). Following the example of Fig. 3e, the input error count (i.e., from the data decoder at the end of the first global iteration) is about 87 (i.e., the y-axis value). The zigzags proceed (line 343) yielding the input to the data detector circuit (i.e., 107 errors) and the input of the data decoder circuit (i.e., 13 errors). This process continues along the vertical and horizontal lines (353, 363, 373). On average, plot 303 shows that three global iterations would be expected to yield convergence.

It is then determined whether data for another global iteration is available (block 477). Where additional data is available (block 477), the next global iteration is selected (block 482) and the processes of blocks 417, 422, 427, 432 and 477 are repeated for the next global iteration. This process continues for all of the available global iterations such that plot 303 of Fig. 3e is expanded to include a number of tunnels corresponding to the different global iterations.

Different channels and different signal to noise ratio conditions have different noise statistics. Therefore the tunnel shape exhibits in the example plot of Fig. 3e will be different for different characteristics. The wider the tunnel between curves 323, 333, the better the sector failure rate performance. The method discussed in relation to Fig. 4 provides an effective way of optimizing codec performance. As just some examples of optimization or improvement, the approach of the methods of Figs. 4a-4c allows for relatively easy optimization of a data processing circuit for use in relation to different channels and different signal to noise ratios by tuning the number of local iterations for respective global iterations to make the tunnel open wider. Alternatively, or in addition, analysis of the plotted EET curves provides an average number of global iterations for a given input error count for a particular sector or data set. In such a case where a data processing circuit receives a data set with too many errors to converge within a timeout window, the data set can be skipped during standard processing and held for retry processing that allows sufficient global iterations. As yet another alternative, the plots may provide a benchmark for use in planning decoder circuit and detector circuit optimization and low density parity check code design. Based upon the disclosure provided herein, one of ordinary skill in the art will recognize other advantages that may be had in relation to different embodiments of the present invention.

Turning to Fig. 5, analysis system 500 is shown in accordance with one or more embodiments of the present invention. Analysis system 500 includes a computer 522 and a computer readable medium 524. Computer 522 may be any processor based device known in the art. Computer readable medium 1124 may be any medium known in the art including, but not limited to, a random access memory, a hard disk drive, a tape drive, an optical storage device or any other device or combination of devices that is capable of storing data. Computer readable medium 524 includes instructions executable by computer 522 to analyze a data processing circuit 526 using error data received therefrom. Such instructions may cause the method of Fig. 3c or Fig. 4c. In some cases, the instructions may be software instructions. Based upon the disclosure provided herein, one of ordinary skill in the art will recognize other types of instructions that may be used in relation to different embodiments of the present invention. In some embodiments of the present invention, data processing circuit 526 may be similar to that discussed above in relation to Fig. 1 or Fig. 2 may be used, and/or the processing may be done similar to that discussed above in relation to Figs. 3a-3b or Figs. 4a-4b.

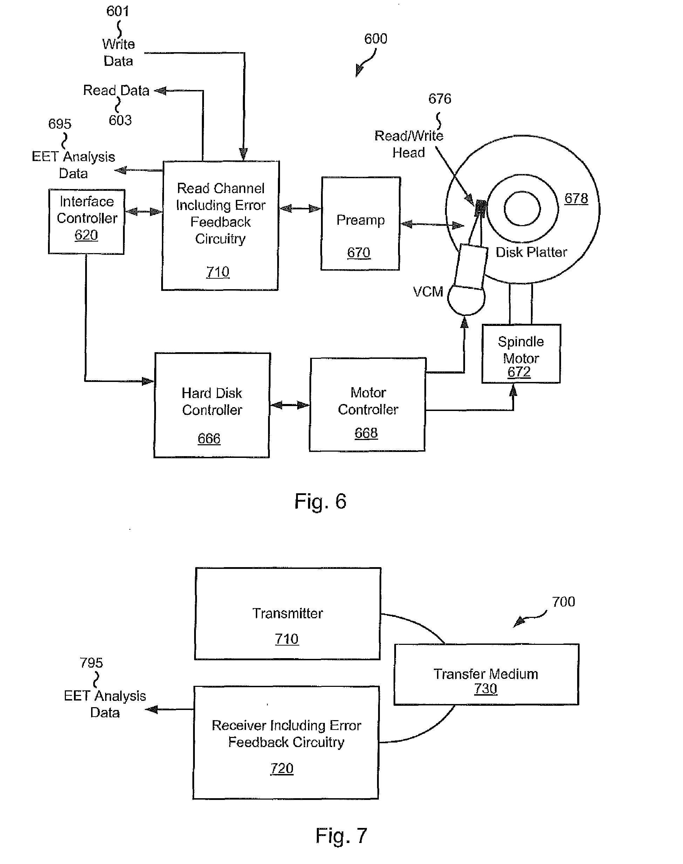

Turning to Fig. 6, a storage system 600 including a read channel circuit 610 having error feedback circuitry is shown in accordance with some embodiments of the present invention. Storage system 600 may be, for example, a hard disk drive. Storage system 600 also includes a preamplifier 670, an interface controller 620, a hard disk controller 666, a motor controller 668, a spindle motor 672, a disk platter 678, and a read/write head assembly 676. Interface controller 620 controls addressing and timing of data to/from disk platter 678. The data on disk platter 678 consists of groups of magnetic signals that may be detected by read/write head assembly 676 when the assembly is properly positioned over disk platter 678. In one embodiment, disk platter 678 includes magnetic signals recorded in accordance with either a longitudinal or a perpendicular recording scheme.

In a typical read operation, read/write head assembly 676 is accurately positioned by motor controller 668 over a desired data track on disk platter 678. Motor controller 668 both positions read/write head assembly 676 in relation to disk platter 678 and drives spindle motor 672 by moving read/write head assembly to the proper data track on disk platter 678 under the direction of hard disk controller 666. Spindle motor 672 spins disk platter 678 at a determined spin rate (RPMs). Once read/write head assembly 678 is positioned adjacent the proper data track, magnetic signals representing data on disk platter 678 are sensed by read/write head assembly 676 as disk platter 678 is rotated by spindle motor 672. The sensed magnetic signals are provided as a continuous, minute analog signal representative of the magnetic data on disk platter 678. This minute analog signal is transferred from read/write head assembly 676 to read channel circuit 610 via preamplifier 670. Preamplifier 670 is operable to amplify the minute analog signals accessed from disk platter 678. In turn, read channel circuit 610 decodes and digitizes the received analog signal to recreate the information originally written to disk platter 678. This data is provided as read data 603 to a receiving circuit. A write operation is substantially the opposite of the preceding read operation with write data 601 being provided to read channel circuit 610. This data is then encoded and written to disk platter 678.

During a read operation, data is sensed from disk platter 678 and processed through a data processing circuit including a data detector circuit and a data decoder circuit. Convergence on the originally written data set may involve one or more global iterations through both the data detector circuit and the data decoder circuit, and one or more local iterations through the data decoder circuit for each global iteration. During an analysis phase, error counts may be enabled from an output of the detector circuit, an output of the decoder circuit at the end of a given global iteration, and/or an output of the decoder circuit at the end of each local iteration. This data is transferred to an analysis system that determines one or more parameter changes for read channel circuit 610 based upon the various numbers of errors. In some embodiments of the present invention, data processing circuits similar to that discussed above in relation to Fig. 1 or Fig. 2 may be used, and/or the processing may be done similar to that discussed above in relation to Figs. 3a-3b or Figs. 4a-4b. The analysis system may be implemented similar to that discussed above in relation to Fig. 5, and may perform an analysis similar to that discussed above in relation to Fig. 3c or Fig. 4c.

It should be noted that storage system 600 may be integrated into a larger storage system such as, for example, a RAID (redundant array of inexpensive disks or redundant array of independent disks) based storage system. Such a RAID storage system increases stability and reliability through redundancy, combining multiple disks as a logical unit. Data may be spread across a number of disks included in the RAID storage system according to a variety of algorithms and accessed by an operating system as if it were a single disk. For example, data may be mirrored to multiple disks in the RAID storage system, or may be sliced and distributed across multiple disks in a number of techniques. If a small number of disks in the RAID storage system fail or become unavailable, error correction techniques may be used to recreate the missing data based on the remaining portions of the data from the other disks in the RAID storage system. The disks in the RAID storage system may be, but are not limited to, individual storage systems such as storage system 600, and may be located in close proximity to each other or distributed more widely for increased security. In a write operation, write data is provided to a controller, which stores the write data across the disks, for example by mirroring or by striping the write data. In a read operation, the controller retrieves the data from the disks. The controller then yields the resulting read data as if the RAID storage system were a single disk.

A data decoder circuit used in relation to read channel circuit 610 may be, but is not limited to, a low density parity check (LDPC) decoder circuit as are known in the art. Such low density parity check technology is applicable to transmission of information over virtually any channel or storage of information on virtually any media. Transmission applications include, but are not limited to, optical fiber, radio frequency channels, wired or wireless local area networks, digital subscriber line technologies, wireless cellular, Ethernet over any medium such as copper or optical fiber, cable channels such as cable television, and Earth-satellite communications. Storage applications include, but are not limited to, hard disk drives, compact disks, digital video disks, magnetic tapes and memory devices such as DRAM, NAND flash, NOR flash, other nonvolatile memories and solid state drives.

Turning to Fig. 7, a data transmission device 700 including a receiver 720 having error feedback circuitry is shown in accordance with some embodiments of the present invention. Data transmission system 700 includes a transmitter 710 that is operable to transmit encoded information via a transfer medium 730 as is known in the art. The encoded data is received from transfer medium 730 by receiver 720.

During operation, data is received by receiver 720 via transfer medium 730 where it is processed through a data processing circuit including a data detector circuit and a data decoder circuit. Convergence on the originally written data set may involve one or more global iterations through both the data detector circuit and the data decoder circuit, and one or more local iterations through the data decoder circuit for each global iteration. During an analysis phase, error counts may be enabled from an output of the detector circuit, an output of the decoder circuit at the end of a given global iteration, and/or an output of the decoder circuit at the end of each local iteration. This data is transferred to an analysis system that determines one or more parameter changes for receiver 720 based upon the various numbers of errors. In some embodiments of the present invention, data processing circuits similar to that discussed above in relation to Fig. 1 or Fig. 2 may be used, and/or the processing may be done similar to that discussed above in relation to Figs. 3a-3b or Figs. 4a-4b. The analysis system may be implemented similar to that discussed above in relation to Fig. 5, and may perform an analysis similar to that discussed above in relation to Fig. 3c or Fig. 4c.

It should be noted that the various blocks discussed in the above application may be implemented in integrated circuits along with other functionality. Such integrated circuits may include all of the functions of a given block, system or circuit, or only a subset of the block, system or circuit. Further, elements of the blocks, systems or circuits may be implemented across multiple integrated circuits. Such integrated circuits may be any type of integrated circuit known in the art including, but are not limited to, a monolithic integrated circuit, a flip chip integrated circuit, a multichip module integrated circuit, and/or a mixed signal integrated circuit. It should also be noted that various functions of the blocks, systems or circuits discussed herein may be implemented in either software or firmware. In some such cases, the entire system, block or circuit may be implemented using its software or firmware equivalent. In other cases, the one part of a given system, block or circuit may be implemented in software or firmware, while other parts are implemented in hardware.

In conclusion, embodiments of the invention provide novel systems, devices, methods and arrangements for data processing. While detailed descriptions of one or more embodiments of the invention have been given above, various alternatives, modifications, and equivalents will be apparent to those skilled in the art. Therefore, the above description should not be taken as limiting the scope of the invention, which is defined by the appended claims.

## Claims

1. A data processing system, the data processing system comprising:
a data processing circuit, wherein the data processing circuit includes:
a data detector circuit operable to apply a data detection algorithm to a sample data set to yield a detected output;
a detected output error count circuit operable to generate an output side error count corresponding to a number of errors remaining in the detected output, wherein the detected output error count circuit is operable to provide the output side error count external to the data processing circuit;
a data decoder circuit operable to apply a data decoding algorithm to the detected output to yield a decoded output; and
a decoded output error count circuit operable to generate an input side error count corresponding to a number of errors remaining in the decoded output, wherein the decoded output error count circuit is operable to provide the input side error count external to the data processing circuit.

2. The data processing system of claim 1, wherein the input side error count is a first input side error count; wherein the decoded output is a first decoded output corresponding to a first local iteration of applying the decoding algorithm to the detected output; and wherein the data decoder circuit is operable to apply the data decoding algorithm to the detected output to yield a second decoded output corresponding to a first local iteration of applying the decoding algorithm to the detected output; and wherein the decoded output error count circuit is further operable to generate a second input side error count corresponding to a number of errors remaining in the second decoded output.

3. The data processing system of claim 1 or 2, wherein the data detection algorithm is selected from a group consisting of: a Viterbi algorithm data detection algorithm, and a maximum a posteriori data detection algorithm.

4. The data processing system of any preceding claim, wherein the data decoder circuit is a low density parity check decoder circuit.

5. The data processing system of any preceding claim, wherein the data processing system is implemented as part of a device selected from a group consisting of: a storage device and a receiving device, preferably wherein the input side error count and the output side error count are provided external to the device.

6. The data processing system of any preceding claim, wherein the data processing system is implemented as part of an integrated circuit, preferably wherein the input side error count and the output side error count are provided external to the integrated circuit.

7. The data processing system of any preceding claim, wherein the system further comprises:
a processor and a computer readable medium, wherein the computer readable medium includes instructions executable by the processor to determine a characteristic of the data processing circuit based at least in part on the input side error count and the output side error count.

8. The data processing system of claim 7, wherein:
the instructions executable by the processor include instructions executable to plot a plurality of output side error counts and a plurality of input side error counts,
preferably wherein the instructions executable by the processor include instructions executable to average the plurality of output side error counts to yield a first curve, and to average the plurality of input side error counts to yield a second curve.

9. A data processing circuit analysis system, the system comprising:
a data processing circuit, wherein the data processing circuit includes:
a data detector circuit operable to apply a data detection algorithm to a sample data set to yield a detected output;
a detected output error count circuit operable to generate an output side error count corresponding to a number of errors remaining in the detected output, wherein the detected output error count circuit is operable to provide the output side error count external to the data processing circuit;
a data decoder circuit operable to apply a data decoding algorithm to the detected output to yield a decoded output; and
a decoded output error count circuit operable to generate an input side error count corresponding to a number of errors remaining in the decoded output, wherein the decoded output error count circuit is operable to provide the input side error count external to the data processing circuit;
a processor and a computer readable medium, wherein the computer readable medium includes instructions executable by the processor to determine a characteristic of the data processing circuit based at least in part on the input side error count and the output side error count.

10. The system of claim 9, wherein the input side error count is a first input side error count; wherein the decoded output is a first decoded output corresponding to a first local iteration of applying the decoding algorithm to the detected output; and wherein the data decoder circuit is operable to apply the data decoding algorithm to the detected output to yield a second decoded output corresponding to a first local iteration of applying the decoding algorithm to the detected output; wherein the decoded output error count circuit is further operable to generate a second input side error count corresponding to a number of errors remaining in the second decoded output; and wherein the characteristic of the data processing circuit includes a desired number of local iterations through the data decoder circuit for a given global iteration.

11. The system of any one of claims 9 or 10, wherein:
the characteristic of the data processing circuit is an expected number of global iterations through the data detector circuit and data decoder circuit for a defined sector failure rate; and/or
the data decoder circuit is a low density parity check decoder circuit.

12. The system of any one of claims 9 to 11, wherein the data detection algorithm is selected from a group consisting of: a Viterbi algorithm data detection algorithm, and a maximum a posteriori data detection algorithm.

13. The system of any one of claims 9 to 12, wherein:
the data processing system is implemented as part of a device selected from a group consisting of: a storage device and a receiving device; and/or
the instructions executable by the processor include instructions executable to plot a plurality of output side error counts and a plurality of input side error counts.

14. The system of claim any one of claims 9 to 13, wherein the instructions executable by the processor include instructions executable to average the plurality of output side error counts to yield a first curve, and to average the plurality of input side error counts to yield a second curve.

15. A storage device, the storage device comprising:
a storage medium;
a head assembly disposed in relation to the storage medium and operable to provide a sensed signal corresponding to information on the storage medium;
a read channel circuit including:
an analog front end circuit operable to provide an analog signal corresponding to the sensed signal;
an analog to digital converter circuit operable to sample the analog signal to yield a series of digital samples;
an equalizer circuit operable to equalize the digital samples to yield a sample set;
a data processing circuit, wherein the data processing circuit includes:
a data detector circuit operable to apply a data detection algorithm to a sample data set to yield a detected output;
a detected output error count circuit operable to generate an output side error count corresponding to a number of errors remaining in the detected output, wherein the detected output error count circuit is operable to provide the output side error count external to the data processing circuit;
a data decoder circuit operable to apply a data decoding algorithm to the detected output to yield a decoded output; and
a decoded output error count circuit operable to generate an input side error count corresponding to a number of errors remaining in the decoded output, wherein the decoded output error count circuit is operable to provide the input side error count external to the data processing circuit.
